# EUROPEAN PATENT APPLICATION

(11) **EP 4 502 737 A1**
(43) Date of publication of application: **05.02.2025**
(21) Application number: 23189330.6
(22) Date of filing: 02.08.2023
(51) Int. Cl.: G05B 17/02, G05B 19/418, G06F 30/20, G06N 5/022

(54) **ENGINEERING AND OPERATIONS SUPPORT SYSTEMS AND METHODS**

(71) Applicant: ABB SCHWEIZ AG, 5400 Baden (CH)
(72) Inventor: SCHOCH, Nicolai, 69120 Heidelberg (DE); HOERNICKE, Mario, 76829 Landau (DE)
(74) Representative: Maiwald GmbH

(57) **Abstract**

There is provided a support system for defining a model representing at least part of an industrial automation system. The support system is configured to:
obtain a user-provided definition of at least part of the model;
process the user-provided definition to verify correctness or completeness of the at least part of the model with reference to at least one knowledge base; and
in response to determining that the user-provided definition comprises incorrect or incomplete information, provide system output, wherein the system output comprises a prompt to the user to provide correct or complete information for inclusion in the definition of the at least part of the model.

## Description

### FIELD OF THE INVENTION

The invention relates to intent-based engineering support systems and methods.

### BACKGROUND

In the field of process and automation engineering, intent-based approaches are gradually replacing requirements-based approaches in the design and engineering of modular process plants. Various tools have been developed in recent years to support the intent-based engineering of modular process plants, such as ontology editors for creating a formalized representation of the engineering intent as an ontology. Nonetheless, existing manual approaches to the creation of engineering intention representations using such ontology editors are error-prone. Missing, ambiguous, or inconsistent information in the engineering intention representations can lead to problems during the design, commissioning, and/or operation of the modular process plant.

### SUMMARY

To better address one or more of these concerns, there is provided, in a first aspect of invention, a support system for defining a model representing at least part of an industrial automation system, wherein the support system is configured to:
obtain a user-provided definition of at least part of the model;
process the user-provided definition to verify correctness or completeness of the at least part of the model with reference to at least one knowledge base; and
in response to determining that the user-provided definition comprises incorrect or incomplete information, provide system output, wherein the system output comprises a prompt to the user to provide correct or complete information for inclusion in the definition of the at least part of the model.

In this way, the system provides systematic and knowledge-based support for engineering and operation of industrial automation systems.

The support system may be configured to trigger the verification of the at least part of the model in response to the occurrence of at least one trigger condition. In one example, the support system is configured to trigger the verification in response to the absence of any user input over a predetermined timeperiod. Additionally or alternatively, the support system may be configured to trigger the verification sporadically or periodically.

The support system may provide a user interface to enable the user to define the at least part of the model. The user interface may form part of an editor or editing tool for creating, editing, saving, and/or exporting the definition of the at least part of the model. The user interface may comprise a graphical user interface. Additionally or alternatively, the user interface may comprise a natural-language user interface (NLUI). The natural language user interface may comprise ChatBot functionality.

The support system may be configured to execute a model verification algorithm for verifying the correctness or completeness of the at least part of the model. The model verification algorithm may be configured to traverse a graph structure of the at least part of the model to identify incorrect or incomplete information. Traversing the graph structure may comprise traversing a hierarchical tree structure of the at least part of the model. Traversing the graph structure structure may comprise iterating over all nodes, or over at least a predetermined subset of all nodes. Traversing the graph structure may comprise traversing in arbitrary dimensions along arbitrary relations of the graph structure. In the case that the graph structure comprises a hierarchical tree structure, traversing the hierarchical tree tree structure may comprise breadthwise iteration over nodes, depthwise iteration over nodes, or any combination thereof.

The model verification algorithm may comprise applying a rule-based or logic-based algorithm to identify the incorrect or incomplete information. The rule-based or logic-based algorithm may be configured to identify incorrect or incomplete information according to one or more criteria defining a correct or complete model. The criteria may be derived from the at least one knowledge base. The knowledge base may comprise at least part of a knowledge graph, and its underlying TBox representation. Thus, the knowledge base with reference to which the verification is performed may comprise the TBox representation. The knowledge base or any part thereof may pertain to at least one domain of interest. The criteria defining the correct or complete model may be derivable from, or obtainable from, the TBox representation. The model verification algorithm may be configured to identify incorrect or incomplete information by comparing an ABox representation of the model provided by the user with the TBox representation. Comparing the ABox representation with the TBox representation may comprise identifying at least one element of the TBox representation which the user has not yet instantiated, so as to identify the said incomplete information. Comparing the ABox representation with the TBox representation may comprise identifying at least one element which the user has incorrectly instantiated, so as to identify the said incorrect information.

The system output, for example including the prompt to the user to provide correct or complete information for inclusion in the definition of the at least part of the model, may be output via the user interface. The support system may be configured to obtain supplementary input from the user comprising the correct or complete information, and to incorporate the supplementary information into the definition of the at least part of the model. The said supplementary input may again be obtained via the user interface. In the case that the user interface comprises an NLUI, information may thus be exchanged between the user and the system in an intuitive manner.

The support system may further comprise autosuggest functionality configured to suggest information to be included in the definition of the at least part of the model, for example to correct or complete information already existing in the model, more particularly to correct or complete information in the ABox part of the model by means of already existing TBox information in the model. The autosuggest functionality may be configured to use historical data to provide suggestions. The historical data may comprise prior models, whether in the form of text or an ontological representation. More particularly, the historical data may comprise examples of historical models, such as engineering intentions expressed in textual form and/or ontological representations of engineering intentions. Based on the historical data, the support system may be configured to suggest information for inclusion in the definition of the at least part of the model, for example for inclusion in a statement currently being edited, in an already-edited statement, and/or in a yet-to-be-edited statement. The support system may be configured to compare the current definition with at least one historical definition and to suggest information for inclusion in the current definition based on at least one difference identified during the comparison. Any such suggestion may form part of the prompt disclosed herein or may be output alongside the prompt as part of the system output.

The support system may comprise a machine learned model trained to identify incorrect or incomplete information in the definition of the at least part of the model. The model may be trained to identify incorrect or incomplete information based on sets of training data, each set comprising at least one user-provided definition of at least part of a model, at least one knowledge base or part thereof (for example an ontological representation or (e.g. partial) knowledge graph), and at least one prompt to the user. The model may be trained to identify incorrect or incomplete information using supervised learning. The model may be further trained using reinforcement learning to reward or penalize outcomes based on the said supplementary information provided by the user in response to the prompt, for example by penalizing a prompt to provide complete information in response to the said supplementary information indicating that the provision of the complete information is impossible.

The system output may further comprise at least one confidence metric. The at least one confidence metric may indicate a confidence in the determination that the user-provided definition comprises incorrect or incomplete information. For example, in the case that a machine learned model is used, a confidence score may also be determined, and provided as part of the system output, to indicate the likelihood that the determination is correct. Determination of the confidence metric may comprise employing at least one domain representation-based logic reasoner to reason whether information entered is correct and complete, for example by identifying matches or mismatches between elements, ruling out elements, identifying unexpected or inconsistent elements, or any combination thereof. The support system may be further configured to increase the confidence in the determination that the user-provided definition comprises incorrect or incomplete information in response to the user (for example, after being prompted by the system) inputting further information. Provision of confidence metrics in this way provides further assistance to the engineer in further completing representations and in becoming aware of possible inconsistencies.

The support system may comprise a machine learned model trained to interact with the user via the user interface, for example a large language model trained to converse with the user via the NLUI.

According to a second aspect, there is provided an industrial automation system or part thereof manufactured according to the model defined using the support system of the first aspect.

According to a third aspect, there is provided a module for an industrial automation system manufactured according to the model defined using the support system of the first aspect.

The model in the second or third aspect may comprise an intention model as described herein.

According to a fourth aspect, there is provided a support method for defining a model representing at least part of an industrial automation system, the method comprising:
obtaining a user-provided definition of at least part of the model;
processing the user-provided definition to verify correctness or completeness of the at least part of the model with reference to at least one knowledge base; and
in response to determining that the user-provided definition comprises incorrect or incomplete information, providing system output, wherein the system output comprises a prompt to the user to provide correct or complete information for inclusion in the definition of the at least part of the model.

Any optional feature or sub-aspect of any of the first-third aspects may form part of the fourth aspect, mutatis mutandis.

According to a fifth aspect, there is provided a manufacturing method for an industrial automation system, the method comprising manufacturing at least part of the industrial automation system according to the model defined using the support method of the fourth aspect.

"Manufacturing" the at least part of the industrial automation system may comprise producing or assembling the at least part of the industrial automation system from components or raw materials. Additionally or alternatively, "manufacturing" the at least part of the industrial automation system may comprise configuring (e.g., reprogramming or repurposing) at least part of a preexisting industrial automation system.

The at least part of the industrial automation system that is manufactured according to the intention model may comprise a module for the automation system. The method of the fifth aspect may comprise integrating the module into the industrial automation system.

According to a sixth aspect, there is provided an operations method for an industrial automation system, the method comprising operating at least part of the industrial automation system to carry out an industrial process according to the model defined using the support method of the fourth aspect.

The method of any of the fourth-sixth aspects may be at least partially computer implemented.

According to a seventh aspect, there is provided a computing system configured to perform the method of any of the fourth-sixth aspects.

According to an eighth aspect, there is provided a computer program (product) comprising instructions which, when executed by a computing system, enable or cause the computing system to perform the method of any of the fourth-sixth aspects.

According to a ninth aspect, there is provided a computer-readable (storage) medium comprising instructions which, when executed by a computing system, enable or cause the computing system to perform the method of any of the fourth-sixth aspects. The computer-readable medium may be transitory or non-transitory, volatile or non-volatile.

The term "domain" as used herein may relate to any industrial domain or field of industry in which automation systems find application, such as the process industry, energy, oil & gas, chemical, petrochemical, and so on. In one example, the domain may comprise a process and automation engineering (P&AE) domain.

By "automation system" is meant a system used for process automation, factory automation, or warehouse automation. The automation system may comprise an industrial facility such as a production plant or process plant for carrying out an industrial process. The industrial process may be a continuous, batch, or discrete process. The automation system may comprise one or more pipelines for transforming one or more educts or raw materials into a product. Additionally or alternatively, the automation system may comprise one or more assembly lines for assembling one or more components into a product. The automation system may be modular or monolithic (i.e., non-modular).

The term "model" as used herein may refer to any model of at least part of the industrial automation system defined using a formal modelling schema.

In one example, the model comprises an intention model. In this example, the support system may be described as an intent-based engineering support system. The term "intention model" denotes a formalized representation of an engineering intent. The intention model may comprise a textual representation of the engineering intent. Additionally or alternatively, the intention model may comprise an ontological representation of the engineering intent. Additionally or alternatively, the intention model may comprise a graph-based representation of the engineering intent.

The model may be useable during any stage of the plant lifecycle, from the engineering stage (process engineering and/or automation engineering) to the operations stage, that is, from design-time to runtime. For example, during the operations stage, the model may be used when implementing a new process recipe. In this case, the support system may be described as an operations support system, or as an engineering and operations support system in the case that it is used across stages.

The term "module" as used herein refers to a process unit encapsulating equipment, instrumentation, and/or controllers to facilitate composition of automation systems in a modular way. A module may be referred to in some contexts as a process equipement assembly (PEA). Functionality of the module may be accessible by way of one or more services. Module services may be orchestrated by a supervisory control system which may be a distributed control system. Module services may be described in a standardized way, for example via a module type package (MTP).

The term "support system", as used herein, which may be referred to as an "engine", "unit", or "tool" as appropriate, may refer to hardware, firmware, and/or software configured to perform any of the operations or algorithms described herein. Hardware may comprise, singly or in any combination, hardwired circuitry, programmable circuitry such as computer processors comprising one or more individual instruction processing cores, or state machine circuitry. Firmware may be embodied as code, instructions and/or data stored or hardcoded in memory devices (e.g., non-volatile memory devices). Software may be embodied as a software package, code, instructions and/or data recorded on at least one transitory or non-transitory computer readable storage medium.

The term "obtaining", as used herein, may comprise, for example, receiving from another system, device, or process; receiving via an interaction with a user; loading or retrieving from storage or memory; measuring or capturing using sensors or other data acquisition devices.

The term "determining", as used herein, encompasses a wide variety of actions, and may comprise, for example, calculating, computing, processing, deriving, investigating, looking up (e.g., looking up in a table, a database or another data structure), ascertaining, and the like. Also, "determining" may comprise receiving (e.g., receiving information), accessing (e.g., accessing data in a memory), and the like. Also, "determining" may comprise resolving, selecting, choosing, establishing and the like.

The indefinite article "a" or "an" does not exclude a plurality. In addition, the articles "a" and "an" as used herein should generally be construed to mean "one or more" unless specified otherwise or clear from the context to be directed to a singular form.

Unless specified otherwise, or clear from the context, the phrases "one or more of A, B and C", "at least one of A, B, and C", and "A, B and/or C" as used herein are intended to mean all possible permutations of one or more of the listed items. That is, the phrase "A and/or B" means (A), (B), or (A and B), while the phrase "A, B, and/or C" means (A), (B), (C), (A and B), (A and C), (B and C), or (A, B, and C).

The term "comprising" does not exclude other elements or steps. Furthermore, the terms "comprising", "including", "having" and the like may be used interchangeably herein.

The invention may include one or more aspects, examples or features in isolation or combination whether specifically disclosed in that combination or in isolation. Any optional feature or sub-aspect of one of the above aspects applies as appropriate to any of the other aspects.

The above-described aspects will become apparent from, and elucidated with, reference to the detailed description provided hereinafter.

### BRIEF DESCRIPTION OF THE DRAWINGS

A detailed description will now be given, by way of example only, with reference to the accompanying drawings, in which:-
FIG. 1 illustrates a modular automation system in connection with which the systems and methods disclosed herein may be practised;
FIG. 2 illustrates a non-limiting example of an intention model for a modular automation system such as that shown in FIG. 1;
FIG. 3 illustrates a non-limiting example of a modularized intention model created by decomposing a larger intention model;
FIG. 4 illustrates a subset of a T-Box of an intention engineering ontology which may be used to create an intention model such as that shown in FIG. 2 or 3;
FIG. 5 illustrates a non-limiting example in which the T-Box of FIG. 4 is instantiated to create an intention model for a use case in the oil & gas industry;
FIG. 6 schematically illustrates a support system and workflow along the main engineering phases, from process to automation engineering, according to the present disclosure; and
FIG. 7 illustrates a computing system that can be used in accordance with the systems and methods disclosed herein.

### DETAILED DESCRIPTION

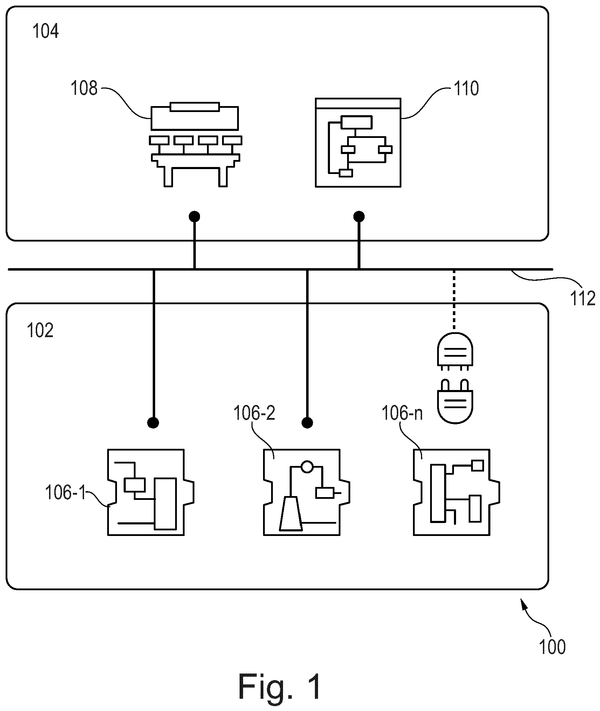

FIG. 1 illustrates a modular automation system 100 in connection with which the systems and methods disclosed herein may be practiced. The modular automation system 100 comprises a module layer 102 and an orchestration layer 104. The module layer 102 comprises a plurality of process modules 106 each comprising a controller executing control logic for the module 106. Each module 106 provides a set of encapsulated process functions, called services, such as mixing, tempering or heating, that can be orchestrated by the orchestration layer 104. The orchestration layer 104 comprises an operations desk 108 and a supervisory control system 110. Communications between entities in the module layer 102 and orchestration layer 104 take place via an architecture network 112 using for example the OPC UA (Unified Architecture) protocol. The orchestration layer 104 integrates the process modules 106 in order to combine them into a process plant. By controlling the services in the right way, the supervisory control system 110 ensures that the modules 106 cooperate to fulfil the requirements of the modular automation system 100 in carrying out an industrial process.

The design and/or manufacture of the modular automation system 100 and/or individual modules 106 may be carried out using an intent-based approach. Intention-based engineering typically begins with intention modelling, for formulating the intent of the plant operator by way of a formalized intent model, which will be used later during plant design. An intent model usually comprises elements at several levels: at least one goal of the plant, defined independently of the later implementation (e.g., independent of the type or number of possible modules); at least one implementation for implementing the goal; and at least one requirement pertaining to each implementation. Associations exist between the different elements so as to model dependencies and causal relationships between the elements. Goals may be formulated initially using controlled natural language. In one non-limiting exemplary use case, referred to hereinafter as Example 1, formulated goals for a process engineering system can be: "I want to achieve separation of the input product "; "I want to achieve constant pressure in the vessel"; "I want to prevent gas leaks out of the vessel". Implementations reflect application of general knowledge to known problems (e.g., choosing standardized PEA types for frequently occurring process steps, using PEA databases, process flow diagrams, etc.). An implementation can represent a specific functionality, technology or decision according to a modular versus monolithic plant part. Finally, requirements are established in terms of parameters (for products and process steps), required technical resources, and products. The requirements represent specific knowledge pertaining to the planning and realization of the specific modular plant (e.g., specific required process parameters, such as temperature, or specific required equipment, such as pressure valves). Requirements may constrain implementations or specify them.

The information about goals, implementations and requirements obtained in this way is subsequently formalized to produce an intention model, which can for example take the form of an ontology (stored for example in the .owl-format) providing a formalized mapping of the relationships between the individual elements of the intention. It will be appreciated that other ways of formalization are possible, for example using other graph-based formats.

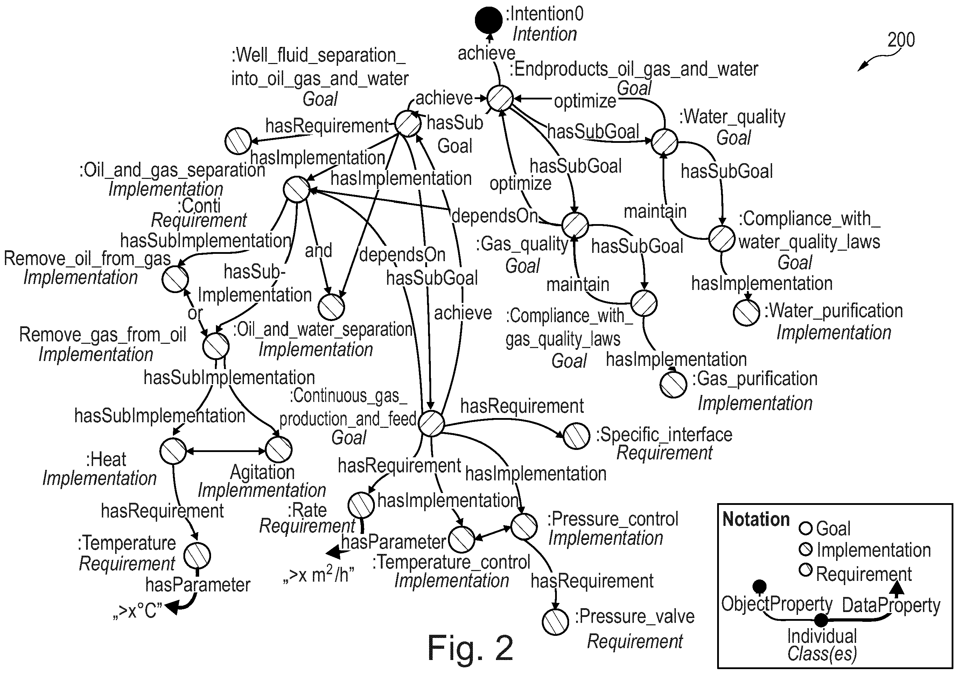

FIG. 2 illustrates one non-limiting example of an intention model 200 for a modular automation system, such as that shown in FIG. 1, for use in separating oil, gas, and water.

In order to be able to set up the requirements with regard to the individual modules 106, the intention model 200 may be modularized.

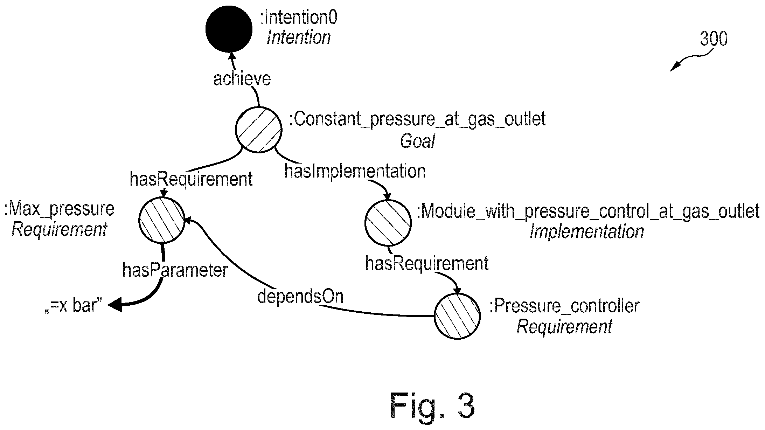

FIG. 3 illustrates one non-limiting example of a modularized intention model 300 created by decomposing a larger intention model into smaller sub-models or partial models.

After modelling goals, implementations, and requirements of an individual module using such a partial model 300, abstract service and module representations may be extracted therefrom, to be used by the module manufacturer as a basis for designing and developing adequate services for the module.

Creation of such ontological (or graph-based) intention models 200, 300 is typically performed by the engineer using an ontology editor (or other tools for similar purposes). Specification of the ontological intention model begins with a TBox, a terminological box, which is a form of statement used in knowledge bases for describing a domain of interest by defining concepts, properties and their relations as a domain vocabulary. TBox statements may be compared to object-oriented classes. The TBox is instantiated by the engineer to create an ABox for the particular use case at hand, where the ABox - the assertion component- describes the instances associated with the elements of the TBox. ABox statements must be TBox-compliant: they are assertions that use the vocabulary defined by the TBox. Together, ABox and TBox statements make up the knowledge base or knowledge graph.

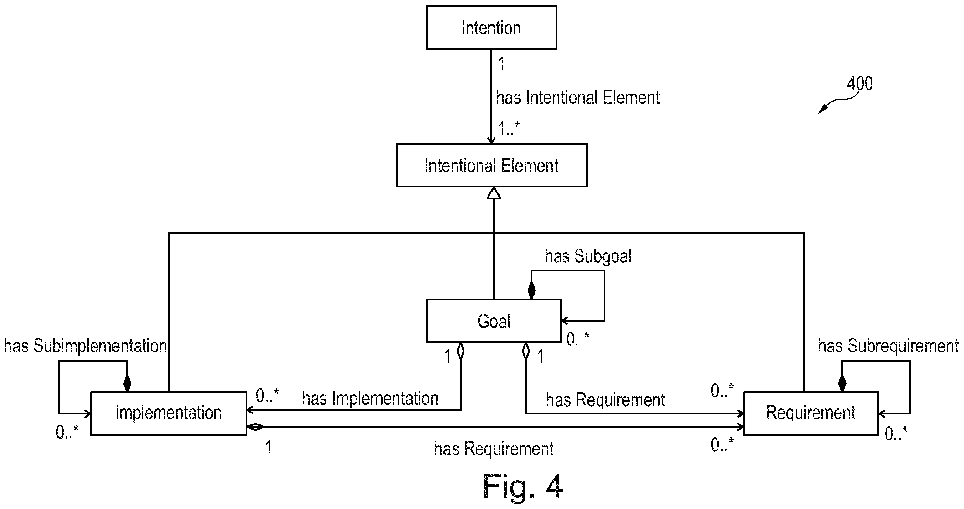

FIG. 4 illustrates one non-limiting example of a subset of a TBox 400 which may be used to create an ontological intention model such as that shown in FIG. 2 or 3.

By instantiating elements of the TBox 400, the engineer is able to create an ABox serving as an ontological intention model for the (specific/individual) use case at hand.

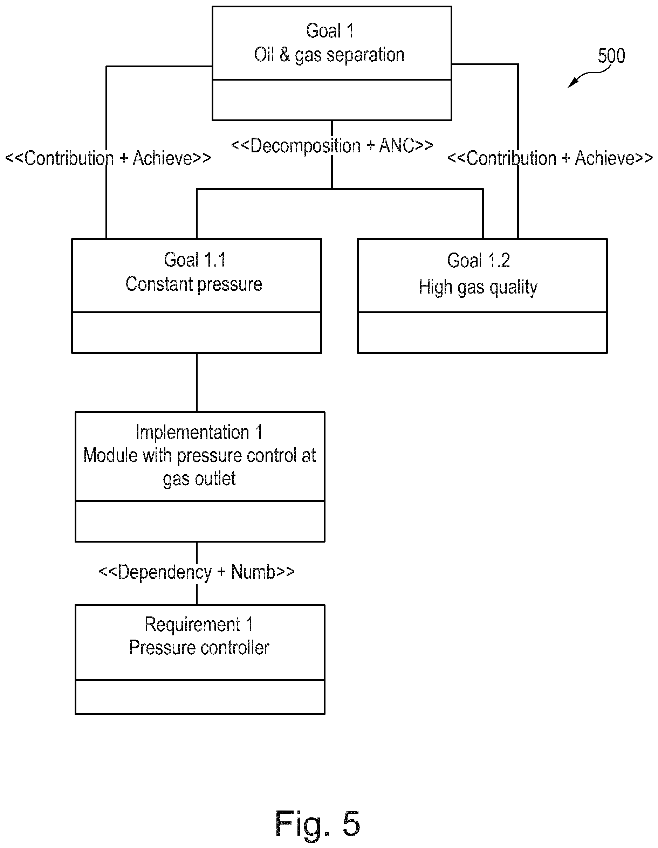

FIG. 5 illustrates one non-limiting example of an ABox 500 serving as an intention model for the use case Example 1 in the oil & gas industry. Goal 1 "Achieve oil & gas separation" is decomposed into two different goals: Goal 1.1, "Achieve constant pressure", and Goal 1.2, "Achieve high gas quality". Furthermore, Implementation 1 "Pressure control at gas outlet" satisfies Goal 1.1, but needs a "Pressure controller" as stated in Requirement 1.

The present disclosure is based on the recognition that the manual process performed by the engineer for defining the intention model using the ontology editor frequently results in an incorrect or incomplete specification of the ontological intention model. Knowledge may be forgotten, ambiguities or inconsistencies may be present, or errors may be made, especially when the model becomes more complex.

The present disclosure proposes therefore an intent-based engineering support system which uses knowledge of the underlying ontology to assist the engineer in specifying a correct and complete ontological intention model.

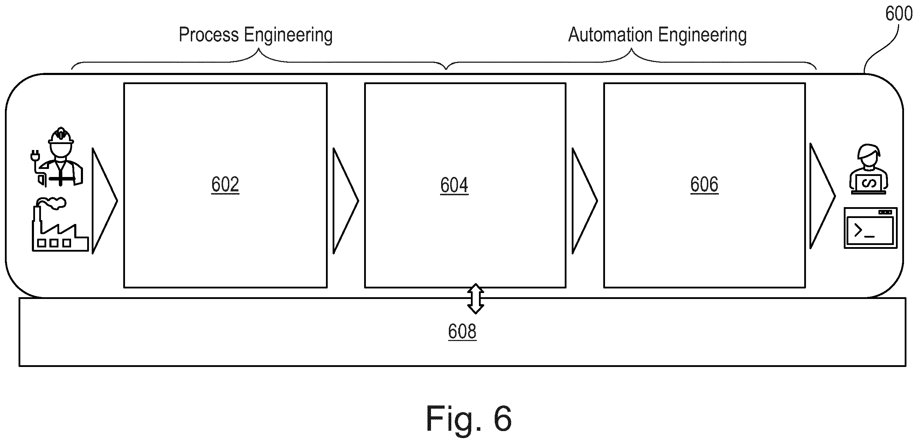

FIG. 6 schematically illustrates the intent-based engineering support system 602 in context. The intent-based engineering support system 602 assists the engineer in connection with intention modelling, intent formalization, generation of abstract service and module representations, and the outputting of specifications. In the non-limiting example depicted in FIG. 6, the intent-based engineering support system forms part of a larger process and automation engineering support system 600 offering further support services for use during one or more other phases of the plant lifecycle optionally including the operations phase. In particular, the process and automation engineering support system 600 further comprises a module pipeline generation system 604 configured to generate module pipelines using specifications output by the intent-based engineering support system 602, to perform optimization and parameter tuning in relation to module pipelines, and to output specifications describing plant topology. The process and automation engineering support system 600 further comprises an orchestration designer system 606 configured to perform orchestration-related processing and manipulation tasks in relation to the plant topology received from the module pipeline generation system 604, to create instances of control software and to export those to the target control system of the automation system 100. The process and automation engineering support system 600 further comprises a semantic facilitation and integration layer 608 configured to provide a common domain vocabulary and concepts, a common knowledge graph, and common APIs for use in the process engineering and automation engineering phases of plant design. The process and automation engineering support system 600 may further comprise an operations support system configured to support the operations team during the operations stage of the industrial automation system 100.

The intent-based engineering support system 602 provides an ontology editor for creating, editing, and saving ontological intention models using a user interface. The user interface in one example comprises a graphical user interface (GUI). Additionally or alternatively, the user interface may comprise a natural-language user interface (NLUI, using for example ChatBot functionality), to enable more intuitive interaction with the engineer, which may take the form of a guided conversation.

Returning to Example 1, the engineer inputs the intentions using the NLUI, "I want to separate oil & gas", and "I want to achieve constant pressure". The intent-based engineering support system 602 creates corresponding goal elements to represent these intentions in the ontological intention model using the ontological statements, "Oil & gas separation", "Constant pressure". The ontological statements may be set up explicitly via the ontology editor (for example, by defining sets of triples: "concept-node, property-edge, concept-node"), or implicitly via an interim GUI or an NLP conversion layer. Elements may be created in this fashion to an arbitrary depth of detail, according to the wishes of the P&AE engineer.

At one or more points during the specification of the ontological intention model, the intent-based engineering support system 602 is triggered to review the correctness and/or completeness of the model as specified so far, and to provide assistance to the user if necessary.

The intent-based engineering support system 602 is configured to trigger an intention model verification algorithm in response to the absence of any user input over a predetermined time period. In this way, the intent-based engineering support system 602 may act as soon as the engineer stops entering information. At this point, based on the ontological model, if for example, the engineer stops entering information at the goal statement level, then the system 602 may prompt the engineer to input information at the implementation statement level which is so far missing in the specification of the intention model.

Additionally or alternatively, the intent-based engineering support system 602 may be configured to trigger the intention model verification algorithm sporadically or periodically, for example to provide early detection of inconsistencies in the information entered via the user interface.

The intention model verification algorithm may be configured to perform a verification of correctness of the partial or complete specification of the intention model. Additionally or alternatively, the intention model verification algorithm may be configured to perform a verification of completeness of the specification of the intention model.

Performing the verification for correctness or completeness may comprise traversing a graph structure, for example a hierarchical tree structure, of the so-far specified intention model to identify incorrect or incomplete information. Traversing the tree structure may comprise iterating over all nodes. Traversing the tree structure may comprise both breadthwise and depthwise iteration over nodes.

The intention model verification algorithm may comprise a rule-based or a logic-based algorithm configured to identify the incorrect or incomplete information. The rules or logic may be configured to identify incorrect or incomplete information according to one or more criteria defining a correct or complete ontology or other kinds of semantic information models. The criteria defining the correct or complete ontology may be based for example on the TBox as described herein. For example, the algorithm may be configured to identify incomplete information by identifying elements of the TBox which the engineer has not yet instantiated with data to create an ABox representation. For example, in the case that the engineer has entered information specifying a goal statement for the intention model, the intention model verification algorithm may identify that an implementation statement is missing on the basis that the implementation element of the TBox is not yet instantiated.

Following the identification of incorrect or incomplete information, the intent-based engineering support system 602 may be configured to prompt the engineer to take action, for example to input correct or complete information.

As disclosed above, the user interface may comprise a GUI and/or an NLUI. In the latter case, returning to Example 1, the intent-based engineering support system 602 may prompt the engineer for example by asking "How do you want to achieve 'constant pressure'?", using the appropriate relation filling-words, "how" and "achieve". The engineer may then provide the requested information either explicitly or implicitly, for example by using the NLUI to input the information, "I want to keep constant pressure using a module with pressure control at the gas outlet". In this way, the engineer is able to use the system 602 to augment the engineering intention representations that were triggered to be further-completed.

The intent-based engineering support system 602 may further comprise autosuggest functionality configured to suggest information to be included in the intention model, for example to correct or complete information already existing in the intention model. The autosuggest functionality may be configured to use historical data to provide suggestions. The historical data may comprise prior intention models, whether in the form of text or an ontological representation. More particularly, the historical data may comprise (well-designed) examples of typical engineering intentions expressed in textual form (e.g., "separate oil and gas", "optimize energy consumption", "maintain pressure", and so on, and/or corresponding representations of these engineering intentions using the the appropriate related ontological model (that is, with goals, implementations, requirements, expressed in terms of domain-specific concepts, e.g. separator, tank, reactor, pressure, etc.), or even already with concrete module specifications (SeparatorModule, ReactionModule, and so on). Based on this historical data, the system 602 may be configured to suggest suitable content for the statement being currently edited, or the next statement to be edited, for example by comparing the current situation with similar historical situations.

Thus, in Example 1, in addition to, or instead of, prompting the engineer by asking "How do you want to achieve 'constant pressure'?", the system 602 may suggest a module with pressure control at the gas outlet as the instantiation value for the implementation statement in the case that the goal statement reads, "I want to achieve constant pressure", on the basis that the system 602 has found a similar situation and implementation in the historical data. The system 602 then outputs the prompt in the form of an autosuggestion, which in the case of the NLUI may read, "Would you like to keep constant pressure by means of using a module with pressure control at the gas outlet?", using the appropriate relation filling-words, e.g., "achieve", "by means of", together with the concept "module with pressure control at gas outlet".

The autosuggest functionality may be configured to filter the historical data to include only those entries that are populated by the same or similar instance values as the current ABox. Based on the additional information in the historical instantiations, the algorithm is configured to propose to the engineer for the current industrial plant at hand that the so-far-missing information (for example at the requirement level) can be filled by instantiation data present in the historical data, for example the instance values that occurred most often in the (filtered) historical data. The autosuggest functionality may be configured to prompt the engineer to indicate the current plant context, and/or to indicate plant context when making suggestions, for example to propose that for a plant in a first domain (e.g., pharma/chem) a first instance value was found to appear most often and that for a plant in a second domain (e.g., an oil & gas plant) a second instance value was found most often in the historical data.

The intent-based engineering support system 602 may comprise a machine learned model trained to identify incorrect or incomplete information in the intention model. More particularly, the model may be trained to have GUI- or NLUI-based conversations with an engineer to identify incorrect or incomplete information in the intention model, and to propose, extract or further define engineering representations.

Training the model may use Supervised Learning and/or out-of-the-box instruction-tuned LLMs (Large Language Models), that optionally are then fine-tuned (made domain-specific) based on training data comprising one or more of the following:-
- ontological (ABox) representations of engineering intention formulations as shown for example in FIG 5;
- the overall ontological domain model representation (complete TBox) as partially shown in FIG. 4;
- prompts (in a format that is suitable for a graphical or natural language Ul) to correct or complete the ontological (ABox) representations (given the complete TBox) (examples of which are provided in the exemplary conversations above).

In this way, the model may be trained to output the prompt to enter correct or complete information given, as input, an engineering intention representation (ABox), while being trained to process the answer appropriately (that is, the reward may be based on whether it is possible to enhance the ABox of the ontological representation). The training may furthermore penalize outcomes with penalty terms when concepts and/or relations do not exist in the overall ontological representation (TBox).

In the case that the user interface comprises an NLUI, the intent-based engineering support system 602 may comprise a machine learned model (e.g., a large language model (LLM) with question-answering-NLP-functionalities, e.g., one of the many open-source free-for-commercial-use out-of-the-box instruction-tuned LLMs (Large Language Models), such as DOLLY), trained to have conversations with an engineer. While Example 1 described above relates to application of the support system 602 during the engineering phase, it will be appreciated that the present disclosure is not so limited and that the support system 602 may additionally or alternatively find application during the operations phase, as will now be described with reference to Example 2.

In Example 2, the operator inputs to the NLUI the intention, "I want to maintain a constant Oil level in the separator for the next 12h", on the basis of which intention representations are defined and mapped to the ontological statement (set of triples concept/relation/concept): "Oil & Gas Separation"; "Constant level"; 12h. This may be performed, as described above, either explicitly by setting the ontological statements up via the ontology editor (by defining sets of triples "concept-node, property-edge, concept-node"), or implicitly via an interim GUI or an NLP conversion layer. This intention representation may be performed to an arbitrary depth of detail, depending on how much information the operator enters.

As described above, the support system 602 is triggered to act as soon as the operator stops entering information or when inconsistencies in the information entered (via GUI/NLUI) are observed. At this point, based on the ontological model, if for example, the operator stops entering information on the "goal statement" level, then the ontology may be used to determine that a typical operations intention would furthermore require an "implementation statement" (which is missing so far). Now, using the NLUI, the ontology-driven support system 602 may request the operator for further information regarding the intention specification: "How do you want to achieve 'constant level'?" with the appropriate relation filling-words, e.g., "how", "achieve". Alternatively, the GUI may be used to prompt the operator at what is missing. The operator can again provide the requested information either explicitly or implicitly (in the above-described way): "I want to maintain constant level using the level controller of the separator vessel xyz"; "I want to maintain constant level by setting the level controllers parameters accordingly"; "I want to switch back the parameters to default after 12h". The support system 602 may then switch the controllers for the level into the required modes and set the parameters accordingly to maintain a constant level during operation.

In summary, the present disclosure provides an ontology-driven intent-based engineering support system (optionally using a graphical or natural language user interface) which assists the process and automation engineer in the creation of formalized ontological engineering intention representations. The properly formulated representations in turn have the effect of reducing or minimizing the occurrence of technical problems or malfunction during the commissioning and operation of automation systems.

In particular examples disclosed herein, the system checks the ontological ABox representation of a concrete current instance with the ontological overall TBox representation of the domain of interest, and thus combines and further complements the ontological ABox (instantiations of concepts) by checking where the TBox (abstract concept and relation/property descriptions) does not yet have instantiations. Furthermore, based on a machine learned model (e.g., based on a large language model (LLM) and with question-answering-NLP-functionalities) the system can interact (e.g. via a graphical UI or via natural language conversations) with an engineer to make suggestions (based on similar historical data) and expand/complement the engineering intention representations.

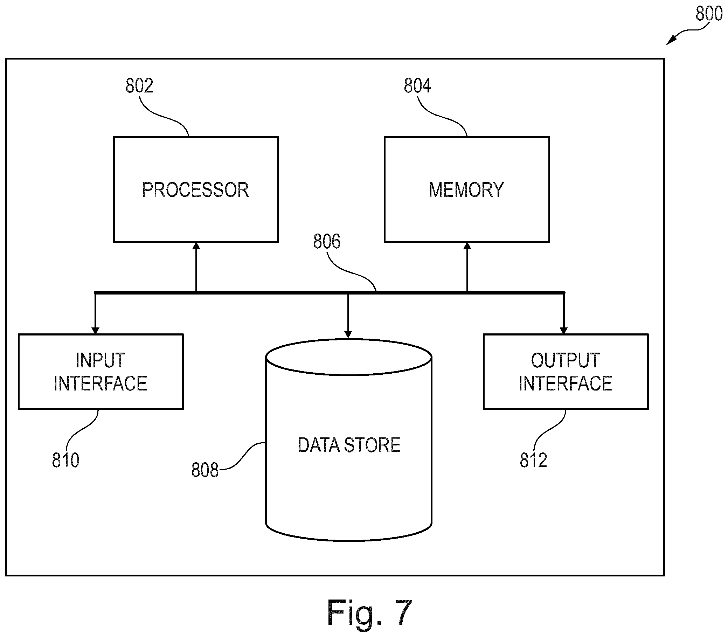

FIG. 7 illustrates an exemplary computing system 800 that can be used in accordance with the systems and methods disclosed herein. The computing system 800 may form part of or comprise any desktop, laptop, server, or cloud-based computing system. The computing system 800 includes at least one processor 802 that executes instructions that are stored in a memory 804. The instructions may be, for instance, instructions for implementing functionality described as being carried out by one or more components described herein or instructions for implementing one or more of the methods described herein. The processor 802 may access the memory 804 by way of a system bus 806. In addition to storing executable instructions, the memory 804 may also store conversational inputs, scores assigned to the conversational inputs, etc.

The computing system 800 additionally includes a data store 808 that is accessible by the processor 802 by way of the system bus 806. The data store 808 may include executable instructions, log data, etc. The computing system 800 also includes an input interface 810 that allows external devices to communicate with the computing system 800. For instance, the input interface 810 may be used to receive instructions from an external computer device, from a user, etc. The computing system 800 also includes an output interface 812 that interfaces the computing system 800 with one or more external devices. For example, the computing system 800 may display text, images, etc. by way of the output interface 812.

It is contemplated that the external devices that communicate with the computing system 800 via the input interface 810 and the output interface 812 can be included in an environment that provides substantially any type of user interface with which a user can interact. Examples of user interface types include graphical user interfaces, natural user interfaces, and so forth. For instance, a graphical user interface may accept input from a user employing input device(s) such as a keyboard, mouse, remote control, or the like and provide output on an output device such as a display. Further, a natural user interface may enable a user to interact with the computing system 800 in a manner free from constraints imposed by input device such as keyboards, mice, remote controls, and the like. Rather, a natural user interface can rely on speech recognition, touch and stylus recognition, gesture recognition both on screen and adjacent to the screen, air gestures, head and eye tracking, voice and speech, vision, touch, gestures, machine intelligence, and so forth.

Additionally, while illustrated as a single system, it is to be understood that the computing system 800 may be a distributed system. Thus, for instance, several devices may be in communication by way of a network connection and may collectively perform tasks described as being performed by the computing system 800.

Various functions described herein can be implemented in hardware, software, or any combination thereof. If implemented in software, the functions can be stored on or transmitted over as one or more instructions or code on a computer-readable medium. Computer-readable media include computer-readable storage media. Computer-readable storage media can be any available storage media that can be accessed by a computer. By way of example, and not limitation, such computer-readable storage media can comprise FLASH storage media, RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Disk and disc, as used herein, include compact disc (CD), laser disc, optical disc, digital versatile disc (DVD), floppy disk, and Blu-ray disc (BD), where disks usually reproduce data magnetically and discs usually reproduce data optically with lasers. Further, a propagated signal may be included within the scope of computer-readable storage media. Computer-readable media also includes communication media including any medium that facilitates transfer of a computer program from one place to another. A connection, for instance, can be a communication medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio and microwave are included in the definition of communication medium. Combinations of the above should also be included within the scope of computer-readable media.

Alternatively, or in addition, the functionally described herein can be performed, at least in part, by one or more hardware logic components. For example, and without limitation, illustrative types of hardware logic components that can be used include Field-programmable Gate Arrays (FPGAs), Program-specific Integrated Circuits (ASICs), Program-specific Standard Products (ASSPs), System-on-a-chip systems (SOCs), Complex Programmable Logic Devices (CPLDs), etc.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features.

It has to be noted that embodiments of the invention are described with reference to different categories. In particular, some examples are described with reference to methods whereas others are described with reference to apparatus. However, a person skilled in the art will gather from the description that, unless otherwise notified, in addition to any combination of features belonging to one category, also any combination between features relating to different category is considered to be disclosed by this application. However, all features can be combined to provide synergetic effects that are more than the simple summation of the features.

While the invention has been illustrated and described in detail in the drawings and foregoing description, such illustration and description are to be considered exemplary and not restrictive. The invention is not limited to the disclosed embodiments. Other variations to the disclosed embodiments can be understood and effected by those skilled in the art, from a study of the drawings, the disclosure, and the appended claims.

The mere fact that certain measures are recited in mutually different dependent claims does not indicate that a combination of these measures cannot be used advantageously.

Any reference signs in the claims should not be construed as limiting the scope.

## Claims

1. A support system for defining a model representing at least part of an industrial automation system, wherein the support system is configured to:
obtain a user-provided definition of at least part of the model;
process the user-provided definition to verify correctness or completeness of the at least part of the model with reference to at least one knowledge base; and
in response to determining that the user-provided definition comprises incorrect or incomplete information, provide system output, wherein the system output comprises a prompt to the user to provide correct or complete information for inclusion in the definition of the at least part of the model.

2. The support system of claim 1, further configured to trigger the verification in response to the absence of any user input over a predetermined timeperiod.

3. The support system of claim 1 or 2, further configured to trigger the verification sporadically or periodically.

4. The support system of any preceding claim, further configured to provide a user interface to enable the user to define the at least part of the intention model, wherein the user interface comprises a natural-language user interface or a graphical user interface.

5. The support system of any preceding claim, further configured to execute an intention model verification algorithm for verifying the correctness or completeness of the at least part of the intention model.

6. The support system of claim 5, wherein the intention model verification algorithm comprises traversing a graph structure of the at least part of the intention model to identify incorrect or incomplete information.

7. The support system of claim 5 or 6, wherein the intention model verification algorithm is configured to identify incorrect or incomplete information by comparing an ABox representation of the intention model provided by the user with a TBox representation.

8. The support system of any preceding claim, further configured to obtain supplementary input from the user comprising the correct or complete information, and to incorporate the supplementary information into the definition of the at least part of the intention model.

9. The support system of any preceding claim, further comprising autosuggest functionality configured to suggest information to be included in the definition of the at least part of the intention model.

10. The support system of claim 9, wherein the autosuggest functionality is configured to use historical data to provide suggestions.

11. The support system of any preceding claim, further comprising a machine learned model trained to identify incorrect or incomplete information in the definition of the at least part of the intention model.

12. The support system of any preceding claim, further comprising a machine learned model trained to converse with the user via a natural language user interface.

13. A support method for defining a model representing at least part of an industrial automation system, the method comprising:
obtaining a user-provided definition of at least part of the model;
processing the user-provided definition to verify correctness or completeness of the at least part of the model with reference to at least one knowledge base; and
in response to determining that the user-provided definition comprises incorrect or incomplete information, providing system output, wherein the system output comprises a prompt to the user to provide correct or complete information for inclusion in the definition of the at least part of the model.

14. A manufacturing method for an industrial automation system, the method comprising manufacturing at least part of the industrial automation system according to the model defined using the support method of claim 13.

15. An operations method for an industrial automation system, the method comprising operating at least part of the industrial automation system to carry out an industrial process according to the model defined using the support method of claim 13.
